# EUROPEAN PATENT SPECIFICATION

(11) **EP 0 434 141 B1**
(45) Date of publication and mention of the grant of the patent: **04.11.1998**
(21) Application number: 90203310.9
(22) Date of filing: 13.12.1990
(51) Int. Cl.: H01L 23/544, H01L 21/00

(54) **Method for encoding identification information on circuit dice using step and repeat lithography**
Informationscodierungsverfahren zur Chipidentifizierung unter Verwendung von schrittlitografischen Methoden
Méthode de codage d'informations visant à identifier des éléments de circuit en utilisant la lithographie pas à pas

(30) Priority: 20.12.1989 US 453544
(43) Date of publication of application: 26.06.1991
(73) Proprietor: Koninklijke Philips Electronics N.V., 5621 BA Eindhoven (NL)
(72) Inventor: Akylas, Victor, NL-5656 AA Eindhoven (NL); Seaborg, Charles, NL-5656 AA Eindhoven (NL)
(74) Representative: Houbiers, Ernest Emile Marie Gerlach

(56) References cited:
- EP-A- 0 057 645
- EP-A- 0 133 955
- US-A- 4 409 686

## Description

The present invention relates in general to a method for encoding identification, serialization, or other information on circuit dice during fabrication.

There is a need for providing identification and other types of information on circuit dice or chips. For example, it may be desirable or necessary in circuit parameter studies to monitor small shifts in the values of the various circuit parameters of a test die over time. In order to observe such shifts accurately, a particular test circuit die must be used for each measurement because the variation of the circuit parameters from die to die may be comparable to, or even larger than, the shifts that are to be monitored. Consequently, some means must be provided by which a particular circuit die can be identified.

The use of visible or optically readable marks and codes is not generally suitable because the dice are encapsulated so that the marks or codes cannot be seen. As a consequence, electrical identification of the dice is the only workable solution, especially for large volumes of parts processed in production, assembly and test facilities. The only other alternative is to maintain art identification with physical means, such as part carriers or identification bins, however, this solution is unworkable with large numbers of parts and the risk of misclassification is unacceptably high.

Electrically coded and read identification of integrated circuit devices are known from e.g. EP-A 0 057 645. This identification serves to identify the circuitry. An identification which enables differentiation of each die on a wafer separately, is not disclosed in EP-A 0 057 645.

In technologies in which there are inherently built-in programmable structures, such as programmable memories, it is a rather straight forward to use these available structures for encoding the identification information into the circuits. However, with other types of circuits that do not include any programmable structures, extra undesirable or even impossible fabrication steps are required to add them which could have an effect on the measured circuit parameters that would defeat the whole purpose of the parameter study. What is needed is a simple method for incorporating identification information into a circuit die during the fabricating of the die.

It is therefore the object of the present invention to provide a method for fabricating circuit dice in which electrically detectable identification information is incorporated into each of the dice during the fabrication process without any programming operation, or incompatible fabrication steps.

This and other objects of the invention are achieved by
a) forming a plurality of electrically readable identification elements (16) on each of a plurality of circuit dice on a semiconductor wafer; and
b) removing, by a photolithographic method, selected ones of said identification elements from each of said circuit dice such that a different one of said plurality of identification elements remains on each said circuit die, so that each said circuit die can be distinguished from one another electrically,
   said step of removing comprising
   i) covering said plurality of circuit dice with a photoresist mask;
   ii) positioning a step and repeat mask above the photoresist mask to cover one of said identification elements on a first circuit die,
   iii) exposing all unmasked identification elements of the first circuit die;
   iv) moving said step and repeat mask over a second different one of said identification elements on a second circuit die on said semiconductor wafer;
   v) exposing all unmasked identification elements of said second circuit die; and
   vi) repeating steps iv) and v) for each circuit die in said semiconductor wafer so that a different unexposed identification element remains on each circuit die, so that each circuit die on said wafer can be distinguished from one another, after the photolithographic process is completed.

In this manner, all of the dice on the wafer can be differentiated from each other by the identification element which differs for each die. In one preferred embodiment of the invention, the element in the array that is left unexposed on each die corresponds with the position of the die on the wafer. Any conventional electrical sensing means can be then employed to sense or detect the presence of the identification element. A multiplexing circuit can be employed to check each of the element locations in the array quickly.

The foregoing and additional objects, features and advantages of the present invention will become apparent from a consideration of the following detailed description of the preferred embodiments thereof taken in conjunction with the accompanying drawings in which:
Figure 1 is a perspective illustration of a semiconductor wafer with a plurality of circuit dice formed thereon; and
Figures 2A-C are partial perspective illustrations of portions of the circuit dice showing the fabrication steps by which an identification element is formed on each circuit die.

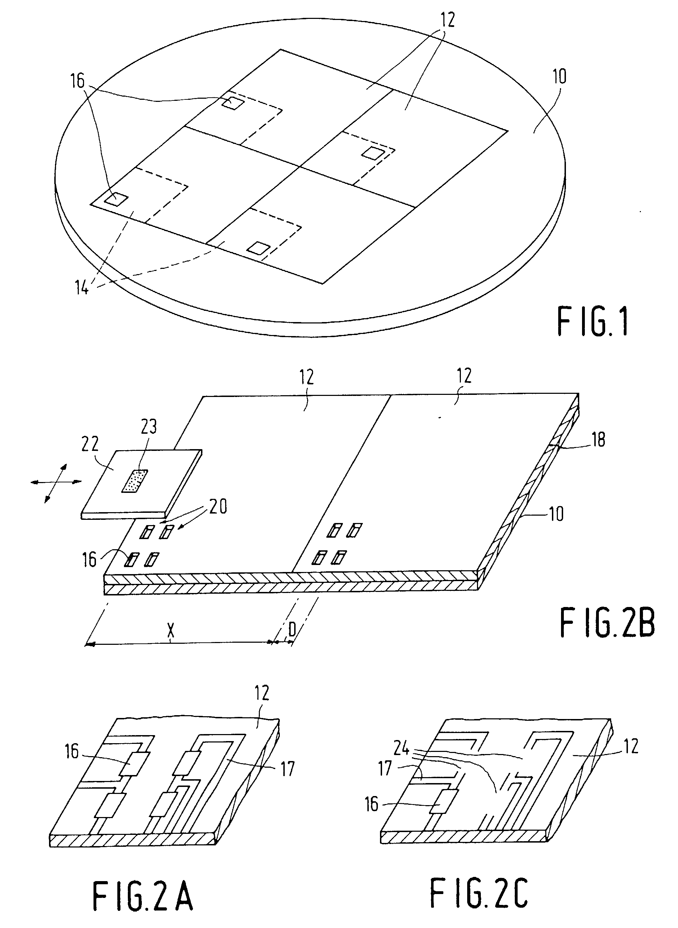

Turning now to a more detailed consideration of the present invention, there is illustrated in Fig. 1, a semiconductor wafer 10 on which are formed a plurality of circuit dice 12. Although only four dice are illustrated in Fig. 1 for convenience, it will be understood that a considerably greater number of circuit dice could be formed in the wafer 10 as is conventional in the art. Disposed in the lower left corner of each of the dice 12 is an identification element array area 14 as illustrated by the dashed lines in Fig. 1. The array area 14 contains a number of identification elements 16, each of which corresponds to one of the circuit dice 12 on the wafer 10. The elements 16 can be any suitable electrically readable element, such as polysilicon resistors, for example. During the fabrication of the circuit dice 12, only one identification element 6 remains on each of the circuit dice 12 and that element is disposed in the array area 14 at a position which corresponds to the position of the circuit die 12 on the wafer 10. As a result, each of the circuit dice 12 has a unique identification element 16 which can be employed to distinguish the circuit dice 12 from one another electrically.

Turning now to Figs. 2A-C, the method by which the identification elements 16 are formed on each of the circuit dice 12 is illustrated. With reference to Fig. 2A, the first step is to form the circuit patterns, including all of the identification elements 16 and a plurality of associated lead lines 17, on each of the circuit dice 12 by using conventional photolithographic techniques. As illustrated in Fig. 2B, the finished circuits are then covered with a photoresist mask 18 which includes a plurality of openings 20 for each of the identification resistors 16. A step and repeat mask 22 is then positioned above the photoresist mask 18 so that a dark area 23 on the mask 22 shields the opening 20 which corresponds to the identification element 16 that is to remain on each of the circuit dice 12.

Step and repeat photolithography is then employed to expose and remove each of the unmasked identification elements 16 from the circuit dice 12. Each exposure step exposes the identification elements on one of the circuit dice 12. After this, the step and repeat mask 22 is stepped a distance equal to the width of the circuit die 12 as denoted by X in Fig. 2B plus the distance D between adjacent identification elements 16. In this manner, the step and repeat mask 22 will be positioned above a different element 16 for each of the circuit dice 12 so that a different identification element 16 will remain on each of the dice 12 after the step and repeat photolithographic process is completed. The final step is to remove the photoresist mask 18 as is conventional in the art thereby leaving the circuits as shown in Fig. 2C with a plurality of open spaces 24 where the removed elements used to be. Any suitable technique is then employed to determine the location of the identification resistor 16 on each of the circuit dice 12 and thereby distinguish each of the circuit dice from each other.

## Claims

1. A method for encoding identification information onto each of a plurality of circuit dice (12) on a semiconductor wafer (10) comprising the steps of:
a) forming a plurality of electrically readable identification elements (16) on each of said plurality of circuit dice on said semiconductor wafer; and
b) removing, by a photolithographic method, selected ones of said identification elements from each of said circuit dice such that a different one of said plurality of identification elements remains on each circuit die, so that each circuit die can be distinguished from one another electrically,
said step of removing comprising:
i) covering said plurality of circuit dice with a photoresist mask;
ii) positioning a step and repeat mask (22) above the photoresist mask to cover one of said identification elements on a first circuit die and
iii) exposing all unmasked identification elements of the first circuit die;
iv) moving said step and repeat mask over a second different one of said identification elements on a second circuit die on said semiconductor wafer:
v) exposing all unmasked identification elements of said second circuit die; and
vi) repeating steps iv) and v) for each circuit die in said semiconductor wafer so that a different unexposed identification element remains on each circuit die, so that each circuit die on said wafer can be distinguished from one another, after the photolithographic process is completed.

## Patentansprüche

1. Verfahren zum Codieren von Identifikationsinformation aufjedem einer Anzahl Chips (12) auf einer Halbleiterkristallscheibe (10), wobei dieses Verfahren die nachfolgenden Verfahrensschritte umfaßt:
a) das Bilden einer Anzahl elektrisch leserlicher Identifikationselemente (16) auf jedem der genannten Anzahl Chips auf der genannten Halbleiterkristallscheibe; und
b) das Entfernen selektierter Elemente der genannten Identifikationselemente von jedem der genannten Chips, nach einem photolithographischen Verfahren, derart, daß ein anderes Element der genannten Anzahl Identifikationselemente aufjedem Chip zurückbleibt, so daß jeder Chip von jedem beliebigen anderen Chip elektrisch unterschieden werden kann,
wobei dieser Entfernungsverfahrensschritt die nachfolgenden Schritte umfaßt:
i) das Bedecken der genannten Anzahl Chips mit einer Photoresistmaske,
ii) das Positionieren einer Schrittmaske (22) über die Photoresistmaske zum Bedecken eines der genannten Identifikationselemente auf einem ersten Chip und
iii) das Belichten aller nichtmaskierten Identifikationselemente des ersten Chips;
iv) das Verlagern der genannten Schrittmaske über ein zweites, anderes Element der genannten Identifikationselemente auf einem zweiten Chip auf der genannten Halbleiterkristallscheibe;
v) das Belichten aller unmaskierten Identifikationselemente des genannten zweiten Chips; und
vi) das Wiederholen der Verfahrensschritte iv) und v) für jeden Chip in der genannten Halbleiterkristallscheibe, so daß ein anderes nicht belichtetes Identifikationselement aufjedem Chip zurückbleibt, so daß jeder Chip auf der genannten Kristallscheibe von einem anderen Chip unterschieden werden kann, nachdem der photolithographische Prozeß beendet ist.

## Revendications

1. Procédé pour encoder des informations d'identification sur chacune d'une pluralité de puces de circuit (12) sur une plaquette à gravure en semi-conducteur (10) comprenant les étapes consistant à :
a) former une pluralité d'éléments d'identification électriquement lisibles (16) sur chacune d'une pluralité de puces de circuit sur ladite plaquette à gravure en semi-conducteur, et
b) supprimer, par un procédé photolithographique, des éléments sélectionnés parmi lesdits éléments d'identification à partir de chacune desdites puces de circuit de sorte qu'un élément différent de ladite pluralité d'éléments d'identification demeure sur chaque dite puce de circuit, de telle sorte que chaque dite puce de circuit peut être différenciée électriquement des autres,
ladite étape de suppression consistant à
i) couvrir ladite pluralité de puces de circuit d'un masque photoresist;
ii) positionner un masque par projection répétitive (22) au-dessus du masque photoresist pour recouvrir l'un desdits éléments d'identification sur une première puce de circuit;
iii) exposer l'ensemble des éléments d'identification non masqués de la première puce de circuit;
iv) déplacer ledit masque par projection répétitive sur un deuxième élément différent desdits éléments d'identification sur une deuxième puce de circuit sur ladite plaquette à gravure en semi-conducteur;
v) exposer tous les éléments d'identification non masqués de ladite deuxième puce de circuit, et
vi) répéter les étapes iv) et v) pour chaque puce de circuit dans ladite plaquette à gravure en semi-conducteur de sorte qu'un élément d'identification différent non exposé demeure sur chaque puce de circuit, de sorte que chaque puce de circuit sur ladite plaquette puisse être différenciée des autres, au terme du procédé photolithographique.
